# EUROPEAN PATENT APPLICATION

(11) **EP 4 770 337 A1**
(43) Date of publication of application: **01.07.2026**
(21) Application number: 25772929.3
(22) Date of filing: 10.03.2025
(51) Int. Cl.: H10F 10/10

(54) **SOLAR CELL AND MANUFACTURING METHOD THEREFOR**

(30) Priority: 20.03.2024 CN 202410323940; 15.01.2025 CN 202510059555; 15.01.2025 CN 202510059553
(71) Applicant: CSI Cells (YangZhou) Co., Ltd., Yangzhou, Jiangsu 225101 (CN)
(72) Inventor: YE, Xiaoya, Suzhou, Jiangsu 215129 (CN); CHEN, Haiyan, Suzhou, Jiangsu 215129 (CN); DENG, Weiwei, Suzhou, Jiangsu 215129 (CN)
(74) Representative: Rapisardi, Mariacristina
(86) International application number: PCT/CN2025/081633
(87) International publication number: WO 2025/195221

(57) **Abstract**

Provided are a solar cell and a manufacturing method therefor. The solar cell includes a silicon substrate (10) including a first surface (S1) and a second surface (S2) opposite to each other, where the first surface (S1) includes a first region (S11) and a second region (S12) arranged at intervals, a tunneling passivation structure is provided on the first region (S11), a passivation structure is provided on the second region (S12), a first electrode (41) electrically connected to the tunneling passivation structure is further provided on the first region (S11), and the width W of the first region (S11) is greater than the width L of the first electrode (41).

## Description

This application claims priority to Chinese Patent Application No. 202410323940.8 filed with the China National Intellectual Property Administration (CNIPA) on Mar. 20, 2024, Chinese Patent Application No. 202510059555.1 filed with the CNIPA on Jan. 15, 2025, and Chinese Patent Application No. 202510059553.2 filed with the CNIPA on Jan. 15, 2025, the disclosures of which are incorporated herein by reference in their entireties.

### TECHNICAL FIELD

The present application relates to the technical field of solar cells, for example, a solar cell and a manufacturing method therefor.

### BACKGROUND

With the rapid development of the photovoltaic industry, the domestic and overseas photovoltaic markets have increasingly high requirements on the performance and efficiency of solar cells, and manufacturers in the industry have been devoted to the research and development of high-efficiency cells. A tunnel oxide passivated contact (TOPCon) cell can improve the surface passivation performance of the cell and reduce a metal-contact recombination current of the cell through an ultrathin tunnel oxide layer and a doped polysilicon layer prepared in sequence on a back surface of the cell, thereby effectively increasing an open-circuit voltage and a short-circuit current of the cell.

The TOPCon cell in the related art generally has a single-sided TOPCon structure. By use of a selective emitter technology on a front surface, a deep junction with a high boron doping concentration is implemented in a metal region, and a shallow junction with a low boron doping concentration is implemented in a non-metal region. However, the recombination in the metal region is still relatively high, which has become a main factor limiting an improvement of cell efficiency. Additionally, boron diffusion on the front surface requires a high temperature above 1000°C, resulting in a relatively high energy consumption. The high temperature and the generated borosilicate glass shorten a service life of quartz tubes, increasing the overall process and equipment cost.

Therefore, it is necessary to provide a solar cell and a manufacturing method therefor.

### SUMMARY

The present application provides a solar cell and a manufacturing method therefor, so as to improve process tolerance and ensure contact passivation performance in metal regions.

An embodiment of the present application provides the technical solutions below.

A solar cell includes a silicon substrate including a first surface and a second surface opposite to each other, where the first surface includes a first region and a second region arranged at intervals, a tunneling passivation structure is provided on the first region, a passivation structure is provided on the second region, a first electrode electrically connected to the tunneling passivation structure is further provided on the first region, and the width W of the first region is greater than the width L of the first electrode.

In an embodiment, a difference between the width W of the first region and the width L of the first electrode is greater than or equal to 40 µm.

In an embodiment, a difference between the width W of the first region and the width L of the first electrode is less than or equal to 600 µm; or a difference between the width W of the first region and the width L of the first electrode is less than or equal to 110 µm.

In an embodiment, the width of the first electrode ranges from 5 µm to 40 µm; and/or the width of the first region ranges from 45 µm to 640 µm or ranges from 45 µm to 150 µm.

In an embodiment, the tunneling passivation structure includes a first tunneling layer and a first doped layer stacked in sequence on the first region, the passivation structure includes a barrier layer and a second doped layer stacked in sequence on the second region, and the first doped layer and the second doped layer are of the same doping type.

In an embodiment, the first electrode is in contact with the first doped layer.

In an embodiment, the barrier layer and the second doped layer on the second region extend laterally into the first region and cover the first tunneling layer and the first doped layer.

In an embodiment, the first electrode is in contact with the second doped layer; or the first electrode is configured to penetrate through the second doped layer and the barrier layer and is in contact with the first doped layer.

In an embodiment, an average doping concentration of the first doped layer is less than or equal to an average doping concentration of the second doped layer; and/or an average doping concentration of the first doped layer ranges from 5E19 cm⁻³ to 5E20 cm⁻³; and/or an average doping concentration of the second doped layer ranges from 1E20 cm⁻³ to 5E20 cm⁻³.

In an embodiment, the thickness of the first doped layer is greater than the thickness of the second doped layer; and/or the thickness of the first doped layer ranges from 30 nm to 300 nm or ranges from 100 nm to 200 nm; and/or the thickness of the second doped layer ranges from 5 nm to 100 nm or ranges from 10 nm to 50 nm.

In an embodiment, the first doped layer is a single doped polysilicon layer or multiple doped polysilicon layers, where doping concentrations of the multiple doped polysilicon layers increase gradiently from inside to outside; and/or the second doped layer is a single doped polysilicon layer or multiple doped polysilicon layers, where doping concentrations of the multiple doped polysilicon layers increase gradiently from inside to outside.

In an embodiment, the first tunneling layer is any one or a combination of a silicon oxide layer or a silicon oxynitride layer; and/or the thickness of the first tunneling layer ranges from 0.5 nm to 3 nm or ranges from 1.5 nm to 2.5 nm; and/or the barrier layer is any one or a combination of a silicon oxide layer or a silicon carbide layer; and/or the thickness of the barrier layer ranges from 0.5 nm to 3 nm or ranges from 1.5 nm to 2.5 nm.

In an embodiment, a second tunneling layer and a third doped layer are stacked in sequence on the second surface of the silicon substrate, a second electrode is further provided on the second surface, the third doped layer has a doping type opposite to a doping type of the first doped layer, and the second electrode is in contact with the third doped layer.

In an embodiment, an average doping concentration of the third doped layer ranges from 3E20 cm⁻³ to 3E21 cm⁻³ or ranges from 5E20 cm⁻³ to 3E21 cm⁻³; and/or the third doped layer is a single doped polysilicon layer or multiple doped polysilicon layers, where doping concentrations of the multiple doped polysilicon layers increase gradiently from inside to outside; and/or the thickness of the third doped layer ranges from 20 nm to 300 nm or ranges from 60 nm to 150 nm; and/or the second tunneling layer is any one or a combination of a silicon oxide layer or a silicon oxynitride layer; and/or the thickness of the second tunneling layer ranges from 0.5 nm to 3 nm or ranges from 1.5 nm to 2.5 nm.

In an embodiment, the silicon substrate is an n-type silicon substrate, the first doped layer and the second doped layer are p-type doped layers, and the third doped layer is an n-type doped layer; and/or a light-trapping structure is formed on the first surface and/or the second surface of the silicon substrate; and/or a first anti-reflection layer is stacked on a second doped layer; and/or a second anti-reflection layer is stacked on the third doped layer.

Another embodiment of the present application provides the technical solutions below.

A manufacturing method for a solar cell includes: providing a silicon substrate including a first surface and a second surface opposite to each other, where the first surface includes a first region and a second region arranged at intervals; preparing a tunneling passivation structure on the first region and preparing a passivation structure on the second region; and preparing a first electrode electrically connected to the tunneling passivation structure on the first region, where the width L of the first electrode is less than the width W of the first region.

In an embodiment, the tunneling passivation structure includes a first tunneling layer and a first doped layer, and the passivation structure includes a barrier layer and a second doped layer; and preparing the tunneling passivation structure, the passivation structure, and the first electrode includes: depositing the first tunneling layer and the first doped layer on the first surface; forming a patterned first mask on the first doped layer in the first region; removing a first tunneling layer on the second region and a first doped layer on the second region by an etching process and/or a texturing process; cleaning and removing the first mask on the first doped layer; preparing the barrier layer and the second doped layer stacked in sequence on the silicon substrate in the second region and the first doped layer in the first region, where the second doped layer and the first doped layer are of the same doping type; and preparing the first electrode in contact with the second doped layer or the first doped layer on the first region of the first surface; where a difference between the width W of the first region and the width L of the first electrode satisfies that W - L ≥ 2X + 2Y, where X denotes a process accuracy for forming the patterned first mask, and Y denotes a process accuracy for preparing the first electrode.

In an embodiment, forming the patterned first mask on the first doped layer in the first region includes: preparing an inorganic mask layer on the first doped layer and patterning the inorganic mask layer by a laser opening process to remove an inorganic mask layer on the second region, where a process accuracy X of the laser opening process is greater than or equal to 15 µm; or preparing an inorganic mask layer on the first doped layer and preparing a patterned organic mask layer on the first region by a screen printing process, where a process accuracy X of the screen printing process is greater than or equal to 15 µm.

In an embodiment, preparing the first electrode includes: printing a metal layer on the first region of the first surface by a screen printing process, where a process accuracy Y of the screen printing process is greater than or equal to 5 µm; and firing the metal layer by a firing process to form the first electrode in ohmic contact with the silicon substrate.

In an embodiment, a difference between the width W of the first region and the width L of the first electrode is greater than or equal to 40 µm.

In an embodiment, a difference between the width W of the first region and the width L of the first electrode is less than or equal to 600 µm; or a difference between the width W of the first region and the width L of the first electrode is less than or equal to 110 µm.

In an embodiment, the width of the first electrode ranges from 5 µm to 40 µm; and/or the width of the first region ranges from 45 µm to 640 µm or ranges from 45 µm to 150 µm.

In an embodiment, an average doping concentration of the first doped layer is less than or equal to an average doping concentration of the second doped layer; and/or an average doping concentration of the first doped layer ranges from 5E19 cm⁻³ to 5E20 cm⁻³; and/or an average doping concentration of the second doped layer ranges from 1E20 cm⁻³ to 5E20 cm⁻³.

In an embodiment, the thickness of the first doped layer is greater than the thickness of the second doped layer; and/or the thickness of the first doped layer ranges from 30 nm to 300 nm or ranges from 100 nm to 200 nm; and/or the thickness of the second doped layer ranges from 5 nm to 100 nm or ranges from 10 nm to 50 nm.

In an embodiment, the manufacturing method further includes: preparing a second tunneling layer and a third doped layer stacked in sequence on the second surface, where the third doped layer has a doping type opposite to a doping type of the first doped layer; and preparing a second electrode in contact with the third doped layer on the second surface.

In an embodiment, preparing the second electrode includes: printing a metal layer on the second surface by a screen printing process; and firing the metal layer by a firing process to form the second electrode in ohmic contact with the silicon substrate.

In an embodiment, the first doped layer, the second doped layer, and the third doped layer each include a doped amorphous silicon layer, and the manufacturing method further includes: annealing the first doped layer, the second doped layer, and the third doped layer at a temperature ranging from 900°C to 980°C to convert the doped amorphous silicon layer into a doped polysilicon layer.

In an embodiment, the manufacturing method further includes: preparing a second mask on the second doped layer, and removing wraparounds of silicon oxide and amorphous silicon on a surface and edges; preparing a third mask on the third doped layer, and removing wraparounds of silicon oxide and polycrystalline silicon on a surface and edges; and removing the second mask and the third mask, and performing cleaning.

In an embodiment, the manufacturing method further includes: preparing a light-trapping structure by a texturing process on the first surface and/or the second surface of the silicon substrate; and/or preparing a first anti-reflection layer on the first surface of the silicon substrate; and/or preparing a second anti-reflection layer on the second surface of the silicon substrate.

### BRIEF DESCRIPTION OF DRAWINGS

FIG. 1A is a structural view of a solar cell according to embodiment one of the present application.
FIG. 1B is an enlarged view of part A in FIG. 1A.
FIG. 1C is a top view of part A in FIG. 1A.
FIGS. 2A to 2J are flow diagrams illustrating a manufacturing process of a solar cell according to embodiment one of the present application.
FIGS. 3A to 3D are flow diagrams illustrating a patterning step according to embodiment two of the present application.

### DETAILED DESCRIPTION

To facilitate understanding of technical solutions of the present application by those skilled in the art, the technical solutions in embodiments of the present application are described below in conjunction with the drawings in the embodiments of the present application. The embodiments described below are part, not all, of embodiments of the present application.

In the present application, unless otherwise expressly specified and limited, when a first feature is described as "on" or "below" a second feature, the first feature and the second feature may be in direct contact with each other or may be in indirect contact with each other via an intermediary. Moreover, when the first feature is described as "on", "above", or "over" the second feature, the first feature may be right on, above, or over the second feature, the first feature may be obliquely on, above, or over the second feature, or the first feature may be simply at a higher level than the second feature. When the first feature is described as "under", "below", or "underneath" the second feature, the first feature may be right under, below, or underneath the second feature, the first feature may be obliquely under, below, or underneath the second feature, or the first feature may be simply at a lower level than the second feature.

The theoretical efficiency of a cell having a single-sided TOPCon structure is 27.1%, and the theoretical efficiency of a cell having a double-sided TOPCon structure is 28.7%. To further improve efficiency, a double-sided tunneling passivated contact structure is required. However, to form a tunneling passivated contact structure on a front surface of the TOPCon cell, a thick poly-Si layer is deposited on the front surface, a mask is added, and part of the poly-Si layer is thinned by a wet etching method, making it difficult to precisely control the thickness of the poly-Si layer in a non-metal region. Such a manner has a narrow process window. If the tunneling passivated contact structure in the non-metal region is not retained, an improvement in cell efficiency is relatively small. A manner of direct laser opening and secondary diffusion also has a complex process flow and a relatively narrow process window difficult to control and requires a high temperature for boron diffusion.

The present application discloses a solar cell. The solar cell includes a silicon substrate including a first surface and a second surface opposite to each other, where the first surface includes a first region and a second region arranged at intervals, a tunneling passivation structure is provided on the first region, a passivation structure is provided on the second region, a first electrode electrically connected to the tunneling passivation structure is further provided on the first region, and the width W of the first region is greater than the width L of the first electrode.

The present application further discloses a manufacturing method for a solar cell. The manufacturing method includes the steps below.

A silicon substrate is provided, where the silicon substrate includes a first surface and a second surface opposite to each other, and the first surface includes a first region and a second region arranged at intervals.

A tunneling passivation structure is prepared on the first region, and a passivation structure is prepared on the second region.

A first electrode electrically connected to the tunneling passivation structure is prepared on the first region, where the width L of the first electrode is less than the width W of the first region.

The width of a metal region and the width of an electrode are set in the present application, which can improve process tolerance, ensure that the electrode is located in the metal region, and ensure contact passivation performance in the metal region.

The solar cell of the present application is a double-sided TOPCon cell having tunneling passivated contact structures on both a front surface and a back surface, ensuring passivated contact in the metal region on the front surface or the metal region on the back surface and reducing parasitic absorption in the metal region on the front surface or a non-metal region on the back surface. Compared with a single-sided TOPCon cell in the related art, the double-sided TOPCon cell has significantly improved cell efficiency, is manufactured by a simple process, and is suitable for mass production.

The present application is described below in combination with embodiments.

### Embodiment one

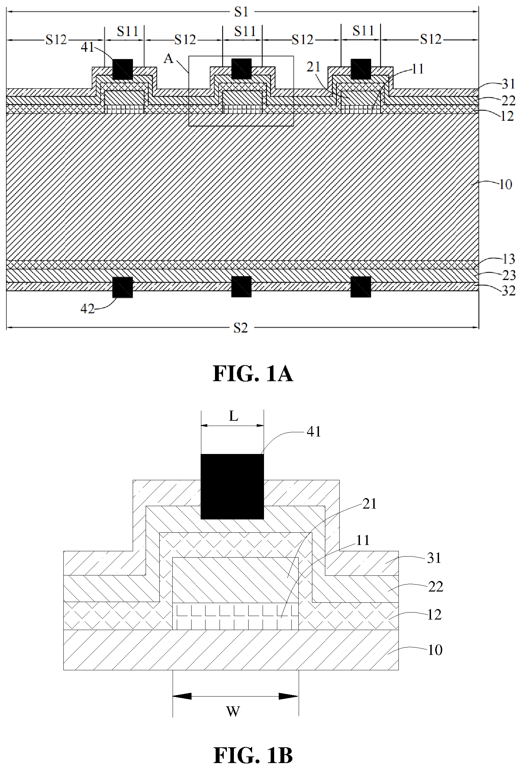

FIGS. 1A and 1B are structural views of a solar cell in this embodiment. The solar cell is a double-sided TOPCon cell and includes a silicon substrate 10. The silicon substrate includes a first surface S1 and a second surface S2 opposite to each other. The first surface S1 includes a first region S11 and a second region S12. The first surface S1 is a front surface (that is, a primary light-receiving surface) of the silicon substrate 10, and the second surface S2 is a back surface (that is, a secondary light-receiving surface) of the silicon substrate 10. The first region S11 is a metal region on the front surface, and the second region S12 is a non-metal region on the front surface. In other embodiments, the first surface S1 may be the back surface (that is, the secondary light-receiving surface) of the silicon substrate 10, and the second surface S2 may be the front surface (that is, the primary light-receiving surface) of the silicon substrate 10. The first region S11 is the metal region on the back surface, and the second region S12 is the non-metal region on the back surface.

In this embodiment, a first tunneling layer 11 and a first doped layer 21 are stacked in sequence on the first region S11, and a barrier layer 12 and a second doped layer 22 are stacked in sequence on the second region S12. The barrier layer 12 and the second doped layer 22 extend laterally into the first region S11 and cover a surface of the first tunneling layer 11 and the first doped layer 12. A second tunneling layer 13 and a third doped layer 23 are stacked in sequence on the second surface S2.

Additionally, first electrodes 41 are distributed on the first surface S1, and a first electrode 41 is located on the first region S11. The first electrode 41 is in contact with the second doped layer 22. Second electrodes 42 are distributed on the second surface S2, and a second electrode 42 is in contact with the third doped layer 23. The first doped layer 21 and the second doped layer 22 are of the same doping type opposite to a doping type of the third doped layer 23.

Optionally, in this embodiment, the thickness of the first doped layer 21 is greater than the thickness of the second doped layer 22.

Optionally, in this embodiment, a first anti-reflection layer 31 is stacked on the second doped layer 22, and a second anti-reflection layer 32 is stacked on the third doped layer 23.

Materials, thicknesses, doping concentrations, etc. of multiple layers in the solar cell of this embodiment are described below.

In this embodiment, the silicon substrate 10 is an n-type silicon substrate with a resistivity ranging from 0.3 Ω·cm to 7 Ω·cm and optionally ranging from 0.5 Ω·cm to 3.5 Ω·cm.

Optionally, light-trapping structures are formed on both the first surface S1 and the second surface S2 of the silicon substrate 10. For example, pyramid textured structures may be formed on the first surface S1 and the second surface S2 of the silicon substrate 10 through alkali texturing.

In this embodiment, each of the first tunneling layer 11 and the second tunneling layer 13 is any one or a combination of a silicon oxide layer or a silicon oxynitride layer and has a thickness ranging from 0.5 nm to 3 nm and optionally ranging from 1.5 nm to 2.5 nm. The barrier layer 12 is any one or a combination of a silicon oxide layer or a silicon carbide layer and has a thickness ranging from 0.5 nm to 3 nm and optionally ranging from 1.5 nm to 2.5 nm.

In this embodiment, each of the first doped layer 21, the second doped layer 22, and the third doped layer 23 may be a single doped polysilicon layer or multiple doped polysilicon layers whose doping concentrations increase gradiently from inside to outside (that is, in a direction away from the substrate). The thickness of the first doped layer 21 ranges from 30 nm to 300 nm and optionally ranges from 100 nm to 200 nm; the thickness of the second doped layer 22 ranges from 5 nm to 100 nm and optionally ranges from 10 nm to 50 nm; and the thickness of the third doped layer 23 ranges from 20 nm to 300 nm and optionally ranges from 60 nm to 150 nm.

Additionally, the first doped layer 21 and the second doped layer 22 are each a p-type doped polysilicon layer, for example, boron-doped; and the third doped layer 23 is an n-type doped polysilicon layer, for example, phosphorus-doped.

An excessively thick second doped layer 22 causes serious light absorption in the non-metal region and a relatively large current loss. Therefore, the thickness of the second doped layer 22 is less than the thickness of the first doped layer 21, which can ensure a passivation effect of the metal region and reduce parasitic light absorption in the non-metal region, effectively improving the photoelectric conversion efficiency of the solar cell. Additionally, both the first doped layer 21 and the second doped layer 22 adopt an annealing process for boron activation. The intermediate barrier layer 12 is relatively thin, and the doping element may diffuse through the barrier layer 12 during annealing. Therefore, average doping concentrations of the first doped layer 21 and the second doped layer 22 have a relatively small difference. In an actual process, the average doping concentration of the first doped layer 21 is slightly less than or equal to the average doping concentration of the second doped layer 22, that is, the average doping concentration of the first doped layer 21 is less than or equal to the average doping concentration of the second doped layer 22.

Optionally, the average doping concentration of the first doped layer 21 ranges from 5E19 cm⁻³ to 5E20 cm⁻³. When the first doped layer 21 is a single p-type doped polysilicon layer, the doping concentration of the first doped layer 21 ranges from 5E19 cm⁻³ to 5E20 cm⁻³. When the first doped layer 21 includes multiple p-type doped polysilicon layers, for example, an inner layer, an intermediate layer, and an outer layer, the doping concentrations of the first doped layer 21 increase gradiently from inside to outside.

The average doping concentration of the second doped layer 22 ranges from 1E20 cm⁻³ to 5E20 cm⁻³. When the second doped layer 22 is a single p-type doped polysilicon layer, the doping concentration of the second doped layer 22 ranges from SE18 cm⁻³ to 5E20 cm⁻³. When the second doped layer 22 includes multiple p-type doped polysilicon layers, for example, an inner layer, an intermediate layer, and an outer layer, the doping concentrations of the second doped layer 22 increase gradiently from inside to outside.

The average doping concentration of the third doped layer 23 ranges from 3E20 cm⁻³ to 3E21 cm⁻³ and optionally ranges from 5E20 cm⁻³ to 3E21 cm⁻³. When the third doped layer 23 is a single n-type doped polysilicon layer, the doping concentration of the third doped layer 23 ranges from 3E20 cm⁻³ to 3E21 cm⁻³. When the third doped layer 23 includes multiple n-type doped polysilicon layers, for example, an inner layer, an intermediate layer, and an outer layer, the doping concentrations of the third doped layer 23 increase gradiently from inside to outside. For example, the doping concentration of the inner layer ranges from 3E20 cm⁻³ to 5E20 cm⁻³, the doping concentration of the intermediate layer ranges from 5E20 cm⁻³ to 1E21 cm⁻³, and the doping concentration of the outer layer ranges from 1E21 cm⁻³ to 3E21 cm⁻³.

In this embodiment, the first anti-reflection layer 31 on the first surface and the second anti-reflection layer 32 on the back surface may each be any one or a combination of a silicon nitride layer, a silicon oxynitride layer, or a silicon oxide layer and have a thickness ranging from 60 nm to 130 nm.

In this embodiment, the first electrode 41 on the first surface may be in contact with the second doped layer 22 or may penetrate through the barrier layer 12 and be in contact with the first doped layer 21 without damaging the bottommost first tunneling layer 11, so as to ensure the tunneling action of the first tunneling layer 11. The second electrode 42 on the second surface is in electrical contact with the third doped layer 23 without damaging the bottommost second tunneling layer 13, so as to ensure the tunneling action of the second tunneling layer 13.

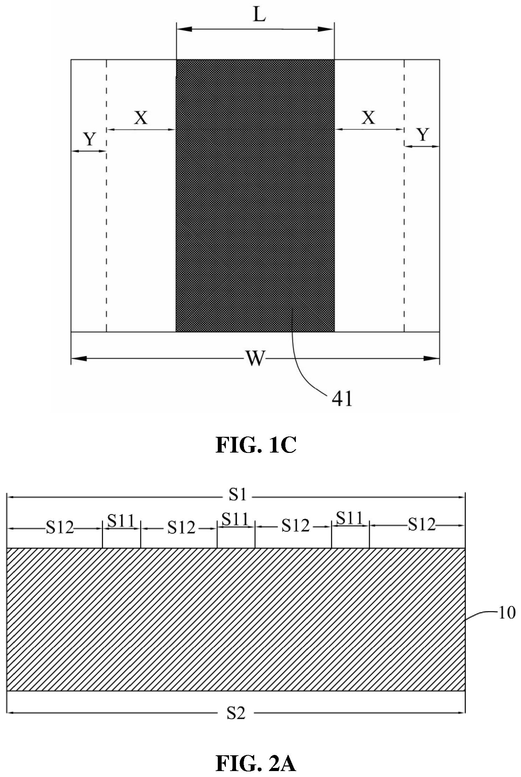

In conjunction with FIGS. 1B and 1C, in this embodiment, the first electrode 41 is located directly on the first region S11, and a projection of the first electrode 41 on the first surface S1 is within the first region S11. With a grid line electrode as an example, the grid line electrode may include multiple busbars and multiple sub-grid lines (also referred to as finger lines) distributed perpendicularly. The busbars are typically prepared from non-fire-through paste. In the present application, the first electrode 41 is described by using a sub-grid line as an example. The width L of the sub-grid line ranges from 5 µm to 40 µm. First regions S11 include multiple line-shaped regions arranged at intervals. The width W of the first region S11 ranges from 45 µm to 640 µm and optionally ranges from 45 µm to 150 µm.

A manufacturing method for the solar cell in this embodiment includes the steps below.

### 1. Double-sided texturing

As shown in FIG. 2A, a silicon substrate 10 is provided. The silicon substrate includes a first surface S1 and a second surface S2 opposite to each other. The first surface S1 includes a first region S11 and a second region S12. The first surface S1 is a front surface (that is, a primary light-receiving surface) of the silicon substrate 10, and the second surface S2 is a back surface (that is, a secondary light-receiving surface) of the silicon substrate 10. The first region S11 is a metal region on the front surface, and the second region S12 is a non-metal region on the front surface. In other embodiments, the first surface S1 may be the back surface (that is, the secondary light-receiving surface) of the silicon substrate 10, and the second surface S2 may be the front surface (that is, the primary light-receiving surface) of the silicon substrate 10. The first region S11 is the metal region on the back surface, and the second region S12 is the non-metal region on the back surface.

In this embodiment, the silicon substrate 10 is an n-type silicon substrate with a resistivity ranging from 0.3 Ω·cm to 7 Ω·cm and optionally ranging from 0.5 Ω·cm to 3.5 Ω·cm. Pyramid textured structures (not shown) are formed on the first surface S1 and the second surface S2 of the silicon substrate by an alkali texturing process.

### 2. Preparation of a first tunneling layer 11 and a first doped layer 21

The first tunneling layer 11 and the first doped layer 21 stacked in sequence are prepared on the first region S11. For example, the steps below are included.

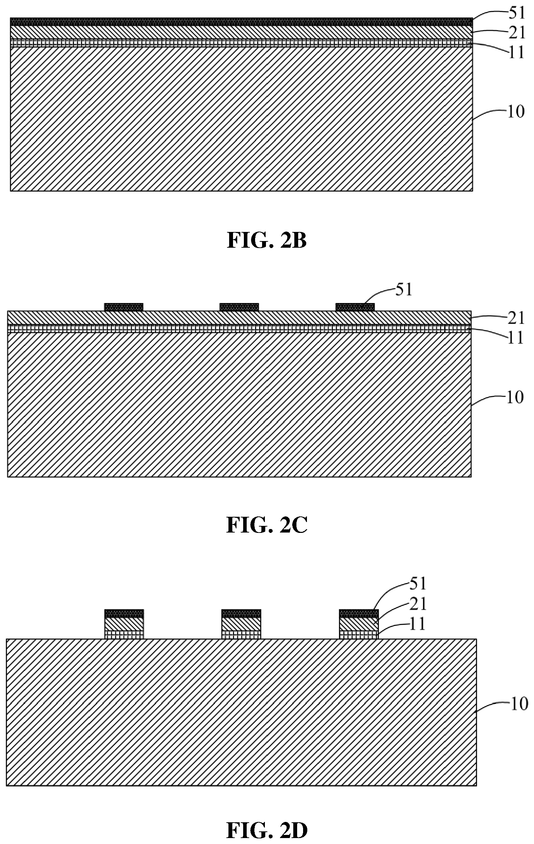

As shown in FIG. 2B, the first tunneling layer 11, the first doped layer 21, and a first mask 51 are deposited on the first surface S1.

For example, in this embodiment, deposition is performed by a plasma-enhanced chemical vapor deposition (PECVD) process. The thickness of the first tunneling layer 11 ranges from 0.5 nm to 3 nm and optionally ranges from 1.5 nm to 2.5 nm. The first doped layer 21 is a boron-doped amorphous silicon layer with an average doping concentration ranging from 5E19 cm⁻³ to 5E20 cm⁻³ and a thickness ranging from 30 nm to 300 nm and optionally ranging from 100 nm to 200 nm. The first mask 51 is an inorganic mask, such as a silicon oxide mask, with a thickness ranging from 5 nm to 50 nm.

As shown in FIG. 2C, a patterned first mask 51 is formed on the first doped layer 21 in the first region S11 through patterning.

For example, in this embodiment, the patterning is performed by a laser opening process. Large-area laser opening is performed on the second region S12 in a laser opening manner to remove the first mask 51 on the second region S12.

As shown in FIG. 2D, the first tunneling layer 11 and the first doped layer 21 on the second region S12 are removed by an etching process and a texturing process.

For example, in this embodiment, the patterned first mask 51 is used for performing secondary texturing on the second region S12 so that the first tunneling layer 11 and the first doped layer 21 deposited on the second region S12 are etched.

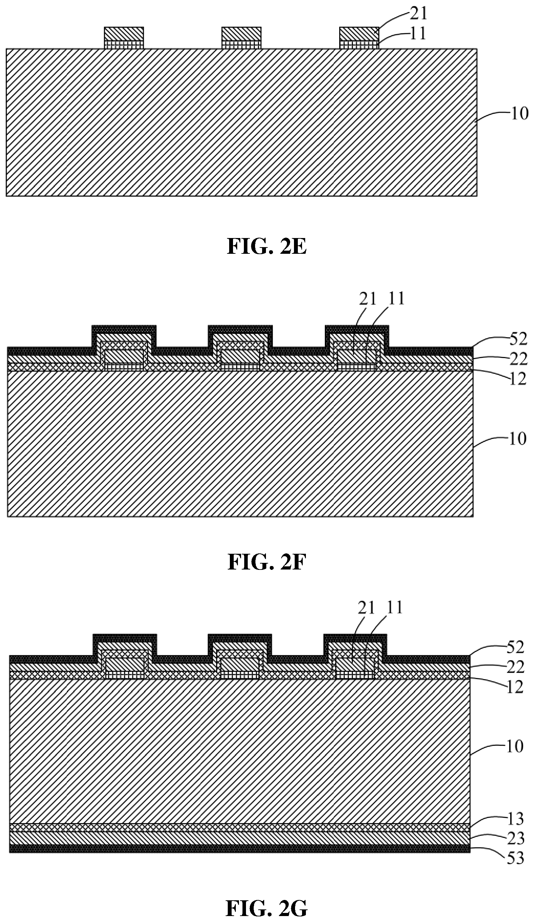

As shown in FIG. 2E, the first mask 51 on the first doped layer is cleaned and removed.

In conjunction with FIG. 1C, considering a process accuracy X of the laser opening process during the patterning by the laser opening process, a certain width needs to be reserved on each of the left and right sides of the first region S 11. For example, if the process accuracy X of the laser opening process in this embodiment is 15 µm, a width of at least 30 µm needs to be reserved as a difference between the width W of the first region S11 and the width L of a first electrode 41.

### 3. Preparation of a barrier layer 12 and a second doped layer 22

As shown in FIG. 2F, the barrier layer 12, the second doped layer 22, and a second mask 52 stacked in sequence are prepared on the second region S12 and the first doped layer 21.

For example, in this embodiment, the deposition is performed by the PECVD process. The thickness of the barrier layer 12 ranges from 0.5 nm to 3 nm and optionally ranges from 1.5 nm to 2.5 nm. The second doped layer 22 is a boron-doped amorphous silicon layer with an average doping concentration ranging from 1E20 cm⁻³ to 5E20 cm⁻³ and a thickness ranging from 5 nm to 100 nm and optionally ranging from 10 nm to 50 nm. The second mask 52 is an inorganic mask, such as a silicon oxide mask, with a thickness ranging from 5 nm to 100 nm.

In this embodiment, the barrier layer 12 and the second doped layer 22 are deposited on the first surface S1. In an actual process, the barrier layer 12 and the second doped layer 22 are not only deposited directly on the second region S12 and the first doped layer 21 but also deposited on sidewalls of the first tunneling layer 11 and the first doped layer 21.

In other embodiments, the barrier layer 12 and the second doped layer 22 may be deposited in regions on the second region S12 and the first doped layer 21, which is not described in detail here.

### 4. Wraparound removal and polishing on the back surface

A wraparound of silicon oxide on the back surface and edges is removed with hydrofluoric acid by using a single-side inline apparatus. A wraparound of amorphous silicon on the edges is removed with an alkali solution. The back surface is polished or micro-textured, followed by RCA (Radio Corporation of America) cleaning.

### 5. Preparation of a second tunneling layer 13 and a third doped layer 23

As shown in FIG. 2G, the second tunneling layer 13, the third doped layer 23, and a third mask 53 stacked in sequence are prepared on the second surface S2.

For example, in this embodiment, the deposition is performed by the PECVD process. The thickness of the second tunneling layer 13 ranges from 0.5 nm to 3 nm and optionally ranges from 1.5 nm to 2.5 nm. The third doped layer 23 is a phosphorus-doped amorphous silicon layer with an average doping concentration ranging from 3E20 cm⁻³ to 3E21 cm⁻³ and optionally ranging from 5E20 cm⁻³ to 3E21 cm⁻³ and a thickness ranging from 20 nm to 300 nm and optionally ranging from 60 nm to 150 nm. The third mask 53 is an inorganic mask, such as a silicon oxide mask, with a thickness ranging from 5 nm to 50 nm.

### 6. Co-annealing

High-temperature annealing is performed on the first doped layer 21, the second doped layer 22, and the third doped layer 23 by using a high-temperature annealing furnace. The annealing temperature ranges from 900°C to 980°C.

The co-annealing can activate doping atoms (phosphorus atoms and boron atoms) in the doped layers, convert the doped amorphous silicon layers into doped polysilicon layers, and form tunneling passivated contact structures on both the front surface and the back surface.

For example, in this embodiment, after the co-annealing, the first doped layer 21 and the second doped layer 22 are converted from the boron-doped amorphous silicon layers to boron-doped polysilicon layers, and the third doped layer 23 is converted from the phosphorus-doped amorphous silicon layer to a phosphorus-doped polysilicon layer.

### 7. Wraparound removal and cleaning

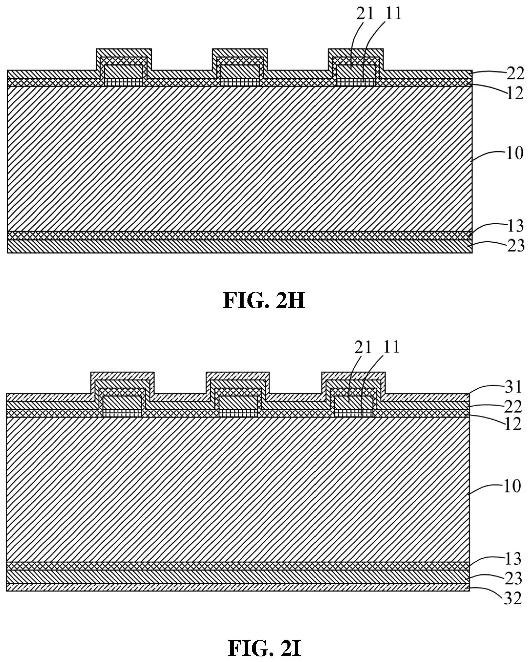

A wraparound of silicon oxide on the first surface and the edges is removed with hydrofluoric acid by using the single-side inline apparatus. A wraparound of polycrystalline silicon on the edges is removed with an alkali solution. As shown in FIG. 2H, the second mask 52 on the first surface and the third mask 53 on the back surface are removed, followed by the RCA cleaning.

### 8. Preparation of anti-reflection layers

As shown in FIG. 2I, the deposition is performed by the PECVD process so that a first anti-reflection layer 31 is prepared on the second doped layer 22, and a second anti-reflection layer 32 is prepared on the third doped layer 23.

For example, in this embodiment, each of the first anti-reflection layer 31 and the second anti-reflection layer 32 may be a silicon nitride layer, may include a silicon nitride layer and a silicon oxynitride layer, or may include a silicon nitride layer, a silicon oxynitride layer, and a silicon oxide layer. The thickness of the anti-reflection layer ranges from 60 nm to 130 nm.

### 9. Preparation of metal electrodes

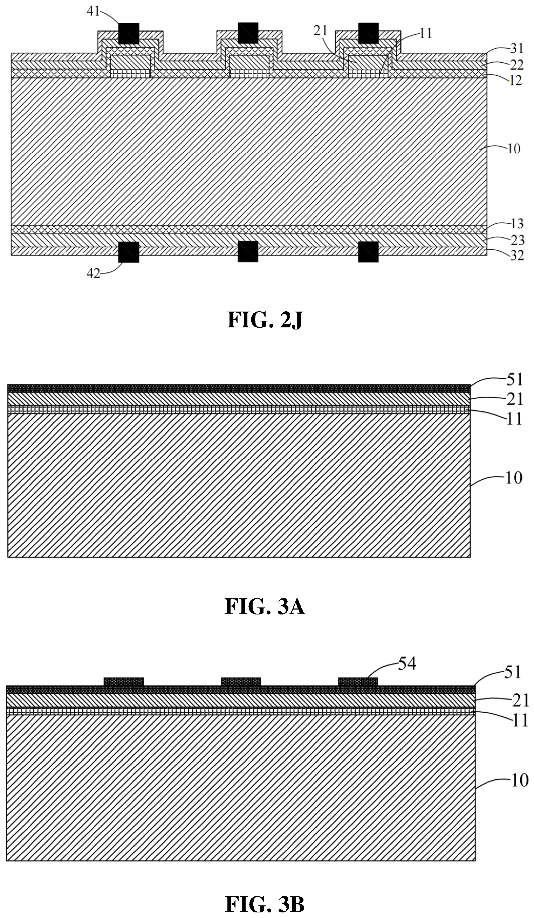

As shown in FIG. 2J, the first electrode 41 in ohmic contact with the silicon substrate 10 is prepared on the first region S11 of the first surface S1, and a second electrode 42 in ohmic contact with the silicon substrate 10 is prepared on the second surface S2.

For example, in this embodiment, metal layers are printed on the first region S11 of the first surface S1 and the second surface S2 respectively by a screen printing process, and the metal layers are fired by a firing process to form the first electrode 41 and the second electrode 42 in ohmic contact with the silicon substrate 10. Finally, a post-treatment is performed on the cell through light injection.

In conjunction with FIG. 1C, considering a process accuracy Y of the screen printing process during electrode preparation by the screen printing process, a certain width needs to be reserved on each of the left and right sides of the first region S11. For example, if the process accuracy Y of the screen printing process in this embodiment is 5 µm, a width of at least 10 µm needs to be reserved as the difference between the width W of the first region S11 and the width L of the first electrode 41.

Double-sided TOPCon cells may be prepared through the preceding steps. Finally, solar cells are tested, sorted, and stored in a warehouse.

Considering the process accuracy of the laser opening process and the process accuracy of the screen printing process, in this embodiment, the difference between the width W of the first region S11 and the width L of the first electrode 41 needs to satisfy that W - L ≥ 2X + 2Y, that is, W - L ≥ 40 µm. Additionally, the density of grid lines affects the cell efficiency, where the larger an interval between the grid lines, the lower the current transmission efficiency. Therefore, the difference between the width W of the first region S11 and the width L of the first electrode 41 needs to be within a certain range. For example, in this embodiment, the difference satisfies that W - L ≤ 600 µm; preferably, W - L ≤ 110 µm.

Based on the above analysis, when the width L of the first electrode 41 in this embodiment ranges from 5 µm to 40 µm, the width W of the first region S11 ranges from 45 µm to 640 µm and optionally ranges from 45 µm to 150 µm. In other embodiments, the width W of the first region S11 is affected by the width L of the first electrode 41, the process accuracy X for forming the patterned first mask, and the process accuracy Y for preparing the first electrode, and the range of W may be adaptively adjusted according to values of L, X, and Y.

### Embodiment two

This embodiment is substantially the same as embodiment one in terms of a structure and a manufacturing method of a solar cell, with a difference lying in the patterning step in step 2 of the manufacturing method.

For example, in embodiment one, a first mask 51 is patterned by a laser opening process. The patterning step in this embodiment includes, for example, the steps below.

As shown in FIG. 3A, a first tunneling layer 11, a first doped layer 21, and the first mask 51 are deposited on the first surface S1. The first mask 51 is an inorganic mask, such as a silicon oxide mask.

As shown in FIG. 3B, a patterned fourth mask 54 is prepared on the first region S11 by a screen printing process. The fourth mask 54 is an organic mask, such as a resin mask.

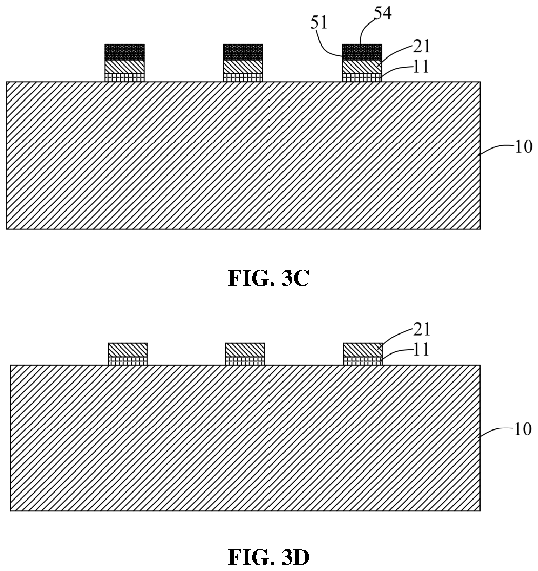

As shown in FIG. 3C, the second region is etched by a wet etching process and subjected to secondary texturing so that the first tunneling layer 11 and the first doped layer 21 on the second region are removed.

Finally, as shown in FIG. 3D, the first mask 51 and the fourth mask 54 on the first doped layer are cleaned and removed.

Similarly, considering a process accuracy X of the screen printing process during the patterning by the screen printing process, a certain width needs to be reserved on each of the left and right sides of the first region S11. For example, if the process accuracy X of the screen printing process in this embodiment is 15 µm, a width of at least 30 µm needs to be reserved as a difference between the width W of the first region S11 and the width L of the first electrode 41.

With reference to embodiment one, in this embodiment, the difference between the width W of the first region S11 and the width L of the first electrode 41 needs to satisfy that W - L ≥ 2X + 2Y, that is, W - L ≥ 40 µm, and satisfy that W - L ≤ 600 µm and optionally, W - L ≤ 110 µm.

### Embodiment three

A manufacturing method for a solar cell in this embodiment includes, for example, the steps below.

### 1. Double-sided texturing

In this embodiment, a silicon substrate is an n-type silicon substrate with a resistivity ranging from 1 Ω·cm to 2 Ω·cm. Pyramid textured structures are formed on a first surface and a second surface of the silicon substrate by an alkali texturing process.

### 2. Preparation of a first tunneling layer and a first doped layer

A tunneling silicon oxide layer with a thickness ranging from 1.5 nm to 2 nm is grown on the first surface by a PECVD process. Then, an intrinsic amorphous silicon layer with a thickness of 10 nm, a lightly doped p-type amorphous silicon layer with a thickness of 50 nm, and a heavily doped p-type amorphous silicon layer with a thickness of 120 nm are deposited in sequence. Finally, a silicon oxide mask layer with a thickness of 20 nm is deposited.

An average doping concentration of the lightly doped p-type amorphous silicon layer ranges from 5E19 cm⁻³ to 6E19 cm⁻³, and an average doping concentration of the heavily doped p-type amorphous silicon layer ranges from 1E20 cm⁻³ to 3E20 cm⁻³.

Large-area laser opening is performed on a second region by a laser opening process so that the silicon oxide mask layer deposited on the second region is removed. Then, a secondary alkali texturing process is performed on the second region so that the first tunneling layer and the first doped layer are etched. Finally, the remaining silicon oxide mask layer is cleaned and removed.

### 3. Preparation of a barrier layer and a second doped layer

A tunneling silicon oxide layer with a thickness ranging from 1.5 nm to 2 nm continues to be grown on the first surface by the PECVD process. Then, an intrinsic amorphous silicon layer with a thickness of 5 nm, a lightly doped p-type amorphous silicon layer with a thickness of 10 nm, and a heavily doped p-type amorphous silicon layer with a thickness of 30 nm are deposited in sequence. Finally, a silicon oxide mask layer with a thickness of 60 nm is deposited.

An average doping concentration of the lightly doped p-type amorphous silicon layer ranges from 1E20 cm⁻³ to 2E20 cm⁻³, and an average doping concentration of the heavily doped p-type amorphous silicon layer ranges from 3E20 cm⁻³ to 5E20 cm⁻³.

### 4. Wraparound removal and polishing on a back surface

A wraparound of silicon oxide on the back surface and edges is removed with hydrofluoric acid by using a single-side inline apparatus. A wraparound of amorphous silicon on the edges is removed with an alkali solution. The back surface is polished or micro-textured, followed by RCA cleaning.

### 5. Preparation of a second tunneling layer and a third doped layer

A tunneling silicon oxide layer with a thickness ranging from 2 nm to 2.5 nm is grown on the second surface by the PECVD process. Then, an intrinsic amorphous silicon layer with a thickness of 15 nm, a lightly doped n-type amorphous silicon layer with a thickness of 30 nm, and a heavily doped n-type amorphous silicon layer with a thickness of 70 nm are deposited in sequence. Finally, a silicon oxide mask layer with a thickness of 20 nm is deposited.

### 6. Co-annealing

High-temperature annealing is performed on the first doped layer, the second doped layer, and the third doped layer by using a high-temperature annealing furnace. The annealing temperature ranges from 900°C to 980°C. The co-annealing can activate doping atoms (phosphorus atoms and boron atoms) in the doped layers and convert the doped amorphous silicon layers into doped polysilicon layers. Meanwhile, the doping atoms diffuse into the intrinsic amorphous silicon layers and convert the intrinsic amorphous silicon layers into doped polysilicon layers. Thus, tunneling passivated contact structures are formed on both a front surface and the back surface.

In other embodiments, the intrinsic amorphous silicon layer may be disposed in an intermediate layer, the lightly doped amorphous silicon layer may be disposed in an inner layer, and the heavily doped amorphous silicon layer may be disposed in an outer layer. After the co-annealing, a structure of inner, intermediate, and outer doped polysilicon layers can also be formed. In this case, the intermediate doped polysilicon layer has a minimum average doping concentration, and the outer doped polysilicon layer has a maximum average doping concentration.

### 7. Wraparound removal and cleaning

A wraparound of silicon oxide on the first surface and the edges is removed with hydrofluoric acid by using the single-side inline apparatus. A wraparound of polycrystalline silicon on the edges is removed with an alkali solution. Finally, the silicon oxide mask layers on the front surface and the back surface are removed, followed by the RCA cleaning.

### 8. Preparation of anti-reflection layers

An anti-reflection layer with a structure of silicon nitride, silicon oxynitride, and silicon oxide is deposited on each of the front surface and the back surface by the PECVD process. The anti-reflection layer has a thickness of 100 nm.

### 9. Preparation of metal electrodes

Metal layers are printed on the first region of the first surface and the second surface respectively by a screen printing process, and the metal layers are fired by a firing process to form a first electrode and a second electrode in ohmic contact with the silicon substrate. Finally, a post-treatment is performed on the cell through light injection.

Double-sided TOPCon cells may be prepared through the preceding steps. Finally, solar cells are tested, sorted, and stored in a warehouse.

For example, in this embodiment, the first electrode and the second electrode each have a width ranging from 5 µm to 40 µm, for example, 15 µm, and the first region S11 has a width ranging from 45 µm to 150 µm, for example, 100 µm.

The double-sided TOPCon cells in the preceding embodiments have a poly-finger structure with local passivated contact, ensuring the passivated contact in the first region and reducing the parasitic absorption in the second region. Compared with the single-sided TOPCon cell in the related art, the double-sided TOPCon cells have significantly improved cell efficiency, are manufactured by a simple process, and are suitable for mass production.

The tunneling layers and the doped amorphous silicon layers are deposited twice by the PECVD process so that the thicknesses of the polysilicon layers can be precisely controlled. A process for manufacturing the poly-finger structure with local passivated contact is more controllable and has a simpler flow.

The intermediate barrier layer is easy to diffuse through via the lower first doped layer to form hole transmission. Moreover, the second doped layer is relatively thin so that electrode paste can easily penetrate through the barrier layer during the firing, avoiding an effect on carrier transmission. The first tunneling layer uses the intrinsic amorphous silicon layer as a buffer layer which can provide a certain window for the lower tunneling layer, ensuring that the lower tunneling layer can still maintain a relatively good passivation effect after the upper tunneling layer is diffused through.

Additionally, in the present application, a high-temperature (above 1000°C) boron diffusion process is not required, and the annealing is simply performed at a temperature ranging from 900°C to 980°C, preventing borosilicate glass (boron trioxide) in the boron diffusion process from corroding a furnace tube, significantly extending a service life of the furnace tube, and reducing an equipment maintenance cost.

The embodiments are to be considered illustrative and non-limiting. The scope of the present application is defined by the appended claims rather than the preceding description and therefore intended to cover all changes that fall within the meaning and scope of equivalents of the claims.

It is to be understood that the specification is described in terms of embodiments, which does not mean that each embodiment includes only one independent technical solution. The recitation of the specification is for clarity only, and those skilled in the art should refer to the specification as a whole.

## Claims

1. A solar cell, comprising:
a silicon substrate comprising a first surface and a second surface opposite to each other, wherein the first surface comprises a first region and a second region arranged at intervals, a tunneling passivation structure is provided on the first region, a passivation structure is provided on the second region, a first electrode electrically connected to the tunneling passivation structure is further provided on the first region, and a width W of the first region is greater than a width L of the first electrode.

2. The solar cell according to claim 1, wherein a difference between the width W of the first region and the width L of the first electrode is greater than or equal to 40 µm.

3. The solar cell according to claim 1, wherein a difference between the width W of the first region and the width L of the first electrode is less than or equal to 600 µm; or
a difference between the width W of the first region and the width L of the first electrode is less than or equal to 110 µm.

4. The solar cell according to claim 1, wherein at least one of the following is satisfied:
the width of the first electrode ranges from 5 µm to 40 µm; or
the width of the first region ranges from 45 µm to 640 µm or ranges from 45 µm to 150 µm.

5. The solar cell according to claim 1, wherein the tunneling passivation structure comprises a first tunneling layer and a first doped layer stacked in sequence on the first region, the passivation structure comprises a barrier layer and a second doped layer stacked in sequence on the second region, and the first doped layer and the second doped layer are of a same doping type.

6. The solar cell according to claim 5, wherein the first electrode is in contact with the first doped layer.

7. The solar cell according to claim 5, wherein the barrier layer and the second doped layer on the second region extend laterally into the first region and cover the first tunneling layer and the first doped layer.

8. The solar cell according to claim 7, wherein the first electrode is in contact with the second doped layer; or the first electrode is configured to penetrate through the second doped layer and the barrier layer and is in contact with the first doped layer.

9. The solar cell according to claim 5 or 7, wherein at least one of the following is satisfied:
an average doping concentration of the first doped layer is less than or equal to an average doping concentration of the second doped layer;
an average doping concentration of the first doped layer ranges from 5E19 cm⁻³ to 5E20 cm⁻³; or
an average doping concentration of the second doped layer ranges from 1E20 cm⁻³ to 5E20 cm⁻³.

10. The solar cell according to claim 5 or 7, wherein at least one of the following is satisfied:
a thickness of the first doped layer is greater than a thickness of the second doped layer;
a thickness of the first doped layer ranges from 30 nm to 300 nm or ranges from 100 nm to 200 nm; or
a thickness of the second doped layer ranges from 5 nm to 100 nm or ranges from 10 nm to 50 nm.

11. The solar cell according to claim 5 or 7, wherein at least one of the following is satisfied:
the first doped layer is a single doped polysilicon layer or a plurality of doped polysilicon layers, wherein doping concentrations of the plurality of doped polysilicon layers increase gradiently from inside to outside; or
the second doped layer is a single doped polysilicon layer or a plurality of doped polysilicon layers, wherein doping concentrations of the plurality of doped polysilicon layers increase gradiently from inside to outside.

12. The solar cell according to claim 5 or 7, wherein at least one of the following is satisfied:
the first tunneling layer is any one or a combination of a silicon oxide layer or a silicon oxynitride layer;
a thickness of the first tunneling layer ranges from 0.5 nm to 3 nm or ranges from 1.5 nm to 2.5 nm;
the barrier layer is any one or a combination of a silicon oxide layer or a silicon carbide layer; or
a thickness of the barrier layer ranges from 0.5 nm to 3 nm or ranges from 1.5 nm to 2.5 nm.

13. The solar cell according to claim 1, wherein a second tunneling layer and a third doped layer are stacked in sequence on the second surface of the silicon substrate, a second electrode is further provided on the second surface, the third doped layer has a doping type opposite to a doping type of the first doped layer, and the second electrode is in contact with the third doped layer.

14. The solar cell according to claim 13, wherein at least one of the following is satisfied:
an average doping concentration of the third doped layer ranges from 3E20 cm⁻³ to 3E21 cm⁻³ or ranges from 5E20 cm⁻³ to 3E21 cm⁻³
the third doped layer is a single doped polysilicon layer or a plurality of doped polysilicon layers, wherein doping concentrations of the plurality of doped polysilicon layers increase gradiently from inside to outside;
a thickness of the third doped layer ranges from 20 nm to 300 nm or ranges from 60 nm to 150 nm;
the second tunneling layer is any one or a combination of a silicon oxide layer or a silicon oxynitride layer; or
a thickness of the second tunneling layer ranges from 0.5 nm to 3 nm or ranges from 1.5 nm to 2.5 nm.

15. The solar cell according to claim 13, wherein at least one of the following is satisfied:
the silicon substrate is an n-type silicon substrate, the first doped layer and the second doped layer are p-type doped layers, and the third doped layer is an n-type doped layer;
a light-trapping structure is formed on at least one of the first surface or the second surface of the silicon substrate;
a first anti-reflection layer is stacked on a second doped layer; or
a second anti-reflection layer is stacked on the third doped layer.

16. A manufacturing method for a solar cell, comprising:
providing a silicon substrate comprising a first surface and a second surface opposite to each other, wherein the first surface comprises a first region and a second region arranged at intervals;
preparing a tunneling passivation structure on the first region and preparing a passivation structure on the second region; and
preparing a first electrode electrically connected to the tunneling passivation structure on the first region, wherein a width L of the first electrode is less than a width W of the first region.

17. The manufacturing method according to claim 16, wherein the tunneling passivation structure comprises a first tunneling layer and a first doped layer, and the passivation structure comprises a barrier layer and a second doped layer; and
preparing the tunneling passivation structure, the passivation structure, and the first electrode comprises:
depositing the first tunneling layer and the first doped layer on the first surface;
forming a patterned first mask on the first doped layer in the first region;
removing a first tunneling layer on the second region and a first doped layer on the second region by at least one of an etching process or a texturing process;
cleaning and removing the first mask on the first doped layer;
preparing the barrier layer and the second doped layer stacked in sequence on the silicon substrate in the second region and the first doped layer in the first region, wherein the second doped layer and the first doped layer are of a same doping type; and
preparing the first electrode in contact with the second doped layer or the first doped layer on the first region of the first surface;
wherein a difference between the width W of the first region and the width L of the first electrode satisfies that W - L ≥ 2X + 2Y, wherein X denotes a process accuracy for forming the patterned first mask, and Y denotes a process accuracy for preparing the first electrode.

18. The manufacturing method according to claim 17, wherein forming the patterned first mask on the first doped layer in the first region comprises:
preparing an inorganic mask layer on the first doped layer and patterning the inorganic mask layer by a laser opening process to remove an inorganic mask layer on the second region, wherein a process accuracy X of the laser opening process is greater than or equal to 15 µm; or
preparing an inorganic mask layer on the first doped layer and preparing a patterned organic mask layer on the first region by a screen printing process, wherein a process accuracy X of the screen printing process is greater than or equal to 15 µm.

19. The manufacturing method according to claim 17, wherein preparing the first electrode comprises:
printing a metal layer on the first region of the first surface by a screen printing process, wherein a process accuracy Y of the screen printing process is greater than or equal to 5 µm; and
firing the metal layer by a firing process to form the first electrode in ohmic contact with the silicon substrate.

20. The manufacturing method according to claim 16, wherein a difference between the width W of the first region and the width L of the first electrode is greater than or equal to 40 µm.

21. The manufacturing method according to claim 16, wherein a difference between the width W of the first region and the width L of the first electrode is less than or equal to 600 µm; or
a difference between the width W of the first region and the width L of the first electrode is less than or equal to 110 µm.

22. The manufacturing method according to claim 16, wherein at least one of the following is satisfied:
the width of the first electrode ranges from 5 µm to 40 µm; or
the width of the first region ranges from 45 µm to 640 µm or ranges from 45 µm to 150 µm.

23. The manufacturing method according to claim 17, wherein at least one of the following is satisfied:
an average doping concentration of the first doped layer is less than or equal to an average doping concentration of the second doped layer;
an average doping concentration of the first doped layer ranges from 5E19 cm⁻³ to 5E20 cm⁻³; or
an average doping concentration of the second doped layer ranges from 1E20 cm⁻³ to 5E20 cm⁻³.

24. The manufacturing method according to claim 17, wherein at least one of the following is satisfied:
a thickness of the first doped layer is greater than a thickness of the second doped layer;
a thickness of the first doped layer ranges from 30 nm to 300 nm or ranges from 100 nm to 200 nm; or
a thickness of the second doped layer ranges from 5 nm to 100 nm or ranges from 10 nm to 50 nm.

25. The manufacturing method according to claim 17, further comprising:
preparing a second tunneling layer and a third doped layer stacked in sequence on the second surface, wherein the third doped layer has a doping type opposite to a doping type of the first doped layer; and
preparing a second electrode in contact with the third doped layer on the second surface.

26. The manufacturing method according to claim 25, wherein preparing the second electrode comprises:
printing a metal layer on the second surface by a screen printing process; and
firing the metal layer by a firing process to form the second electrode in ohmic contact with the silicon substrate.

27. The manufacturing method according to claim 25, wherein the first doped layer, the second doped layer, and the third doped layer each comprise a doped amorphous silicon layer, and the manufacturing method further comprises:
annealing the first doped layer, the second doped layer, and the third doped layer at a temperature ranging from 900°C to 980°C to convert the doped amorphous silicon layer into a doped polysilicon layer.

28. The manufacturing method according to claim 27, further comprising:
preparing a second mask on the second doped layer, and removing wraparounds of silicon oxide and amorphous silicon on a surface and edges;
preparing a third mask on the third doped layer, and removing wraparounds of silicon oxide and polycrystalline silicon on a surface and edges; and
removing the second mask and the third mask, and performing cleaning.

29. The manufacturing method according to claim 16, further comprising at least one of:
preparing a light-trapping structure by a texturing process on at least one of the first surface or the second surface of the silicon substrate;
preparing a first anti-reflection layer on the first surface of the silicon substrate; or
preparing a second anti-reflection layer on the second surface of the silicon substrate.
